# EUROPEAN PATENT APPLICATION

(11) **EP 4 682 644 A1**
(43) Date of publication of application: **21.01.2026**
(21) Application number: 24212735.5
(22) Date of filing: 13.11.2024
(51) Int. Cl.: G04F 5/14, G01C 19/62, G01R 33/26, G04D 7/00, H03L 7/26, G04F 13/02, G04G 7/00

(54) **ATOMIC VAPOR CELL AND CONFIGURATION OF AN ATOMIC OPTICAL CLOCK IMPLEMENTING SAID ATOMIC VAPOR CELL**

(30) Priority: 16.07.2024 CH 7652024
(71) Applicant: ROLEX SA, 1211 Genève 26 (CH)
(72) Inventor: KARLEN, Sylvain, 2000 Neuchâtel (CH); LECOMTE, Steve, 1233 Bernex (CH); DROZ, Fabien, 2075 Thielle (CH)
(74) Representative: Moinas & Savoye SARL

(57) **Abstract**

System (30) for the control, adjustment, or certification of timepieces comprising means (31) to measure the frequency signal and/or the rate of a timepiece or of several timepieces, based on a time reference provided by an optical atomic clock (10), said optical atomic clock (10) comprising an atomic vapor cell (1),
the atomic vapor cell (1) comprising a hermetically sealed enclosure (8) defining a volume containing a vapor of reference atoms (2),
said hermetically sealed enclosure (8) comprising an optical inlet (3) allowing the transmission of a probe beam adapted to excite an optical transition of said reference atoms (2), and an optical outlet (4) allowing the transmission of a fluorescence signal from said reference atoms (2),
said hermetically sealed enclosure (8) further comprising a wall (5), transparent to said fluorescence signal, which is coated on its outer side with a coating (6) reflective to said fluorescence signal.

## Description

### Technical Field

The invention is in the field of optical atomic clocks. More specifically, it relates to a vapor cell configured for optimal collection of the fluorescence emitted by a vapor of reference atoms contained in said cell. The invention also relates to methods of fabrication of said cell and the configuration of an optical atomic clock using said vapor cell as an atomic frequency reference. The invention also relates to systems for the control, adjustment, or certification of timepieces.

### State of the art

Atomic clocks are highly stable frequency standards increasingly used in applications such as navigation and telecommunications, as well as for high-end scientific instrumentation. Unlike the first generations of microwave atomic clocks, optical atomic clocks are based on atomic optical transitions as a frequency reference.

Several schemes of optical atomic clocks have been proposed based on two-photon transitions. Advantageously, a two-photon transition can be observed via a fluorescence signal which can be spectrally separated from the probe laser. Probing a two-photon transition can also be advantageously configured in a doppler-free scheme, resulting in a narrow absorption band with high frequency precision.

One example of a two-photon optical atomic clock can be found in the scientific publication by Perrella et al.: "Dichroic Two-Photon Rubidium Frequency Standard", PHYSICAL REVIEW APPLIED 12, 054063 (2019), hereinafter referred to as "Perrella". This paper discloses a two-photon scheme based on the monitoring of the fluorescence of Rubidium atoms resulting from the two-photon absorption of, in this case, two probe lasers of different wavelengths. In this paper, the authors clearly expose a general problem encountered in this type of scheme, namely, the relatively low intensity of the collected fluorescence signal, which leads to a small photocurrent at the detector and translates into a significant effect of shot noise degrading the stability of the clock. According to the authors, this low photocurrent is partly due to poor collection efficiency, which they estimate to be approximately 0.2% of the total emitted fluorescence.

Clearly, there is a need for an optical scheme providing a higher collection efficiency of the fluorescence of atomic reference atoms in a vapor cell.

Another known problem also commented on in "Perrella", which relates to the problem of collection efficiency, is that, in order to capture the largest possible number of fluorescence photons, their photodetector, a photomultiplier tube (PMT), is positioned in close proximity to the Rubidium cell, which is kept at a temperature of 90 °C to increase the Rb vapor density. This proximity raises the temperature of the PMT and consequently, its dark noise, which also has a degrading effect on the frequency stability of the clock. Thus, there is a need for an optical scheme providing high collection efficiency while reducing the impact of vapor cell heating on the temperature-sensitive photodetector.

### Disclosure of the invention

According to a first aspect of the invention, the objectives above are achieved by the provision of an atomic vapor cell as defined by the following proposals.
1- Atomic vapor cell (1), comprising a hermetically sealed enclosure (8) defining a volume containing a vapor of reference atoms (2), said hermetically sealed enclosure (8) comprising an optical inlet (3) allowing the transmission of a probe beam adapted to excite an optical transition of said reference atoms (2), and an optical outlet (4) allowing the transmission of a fluorescence signal from said reference atoms (2); **characterized in that** said hermetically sealed enclosure (8) further comprises a wall (5), transparent to said fluorescence signal, which is coated on its outer side with a coating (6) reflective to said fluorescence signal.
2- Atomic vapor cell (1) according to proposal 1, wherein said wall (5) represents more than 50%, preferably more than 80%, of the external surface of the hermetically sealed enclosure (8).
3- Atomic vapor cell (1) according to proposal 1 or 2, wherein said coating (6) reflects more than 70%, preferably more than 80%, of the fluorescence signal, averaged over all possible angles of incidence.
4- Atomic vapor cell (1) according to any of proposals 1 to 3, wherein the optical inlet (3), the optical outlet (4), and the wall (5) are monolithically constructed comprising a material or a combination of materials transparent to both the probe and the fluorescence signals.
5- Atomic vapor cell (1) according to any of proposals 1 to 4, wherein the coating (6) comprises a metallic layer or an interferential mirror.
6- Atomic vapor cell (1) according to any of proposals 1 to 5, wherein the outer side of the wall (5) comprises a textured area (13).
7- Atomic vapor cell (1) according to proposal 6, wherein said the textured area (13) comprises microscopic or macroscopic faces, for example frustoconical faces, arranged such as to preferentially reflect an incident fluorescence signal in the direction of the optical outlet (4).
8- Atomic vapor cell (1) according to one of proposals 1 to 7, wherein said optical inlet (3) and optical outlet (4) are one and the same element.

According to a second aspect of the invention, methods are provided for the fabrication of such an atomic vapor cell, as defined by the following proposals.
9- Method for fabricating an atomic vapor cell according to any of the proposals 1 to 8 comprising the steps of:
   (S1) providing a cell body comprising an enclosure (8) comprising a transparent wall (5), and a connector (9) defining an opening in said enclosure (8);
   (S2) cleaning the inner surface of said cell body by a process comprising outgassing and plasma cleaning;
   (S3) Introducing a vapor of reference atoms (2) into the enclosure (8) through the connector (9);
   (S4) hermetically sealing the connector (9) to obtain a hermetically sealed enclosure (8) defining a volume containing a vapor of reference atoms (2); and
   (S5) depositing a coating apt to reflect a fluorescence signal of said reference atoms (2) on at least part of the surface of said transparent wall (5).
10- Method according to proposal 9, further including a step (S6) comprising texturing the outer area of said transparent wall (5), said step (S6) being performed at any stage before said step (S5).
11- Method according to proposal 9 or 10, wherein said step (S5) comprises depositing a metal layer, notably by physical vapor deposition (PVD) or by chemical vapor deposition (CVD) or by atomic layer deposition (ALD).

According to a third aspect of the invention, the objectives above are further solved by the provision of an optical atomic clock comprising a signal collection scheme according to any of the following proposals.
12- Optical atomic clock (10) comprising an atomic vapor cell (1) according to any of proposals 1 to 8.
13- Optical atomic clock (10) according to proposal 12, comprising:
   - a laser source adapted to generate a laser probe beam (11) adapted to excite a two-photon optical transition of said reference atoms (2),
   - a dichroic mirror (12) adapted to discriminate said probe beam (11) and a fluorescence signal (9) of said reference atoms (2), and
   - a photodetector (17).
14- Optical atomic clock (10)according to proposal 13, wherein the probe beam (11), the atomic vapor cell (1), and the dichroic mirror (12) are configured such that, in operation:
   - the probe beam (11a) enters the atomic vapor cell (1) through its optical inlet (3), crosses the volume containing a vapor of reference atoms (2) through a defined optical path until the optical outlet (4), crosses the optical outlet (4), reaches the dichroic mirror (12) and is reflected backwards into the optical outlet (4) towards the optical inlet (3) across said defined optical path, and
   - the fluorescence signal (9) of said reference atoms (2) is transmitted through the optical outlet (4) towards the photodetector (17).
15- Optical atomic clock (10) according to proposal 13, wherein the atomic vapor cell (1) is according to proposal 8 and wherein the probe beam (11), the atomic vapor cell (1), and the dichroic mirror (12) are configured such that, in operation:
   - the probe beam (11a) is transmitted through the dichroic mirror (12), enters the atomic vapor cell (1) through its optical inlet (3), crosses the volume containing a vapor of reference atoms (2) through a defined optical path until a mirror and is reflected backwards towards the optical inlet (3) across said defined optical path, and
   - the fluorescence signal (9) of said reference atoms (2) is transmitted through the optical outlet (4), reaches the dichroic mirror (12) and is reflected towards the photodetector (17).
16- Optical atomic clock (10) according to one of proposals 12 to 15, further comprising a light pipe (14) configured to capture the fluorescence signal (9) emitted from the atomic vapor cell (1), in particular through the optical outlet (4), and to transfer said fluorescence signal (9) to the photodetector (17).
17- Optical atomic clock (10) according to proposal 16, wherein the light-pipe (14) has a tubular form, defining a pipe inlet face (15), a pipe outlet face (16), and reflective walls, wherein the shape of the pipe inlet face (15) is substantially equal to or larger than the shape of the atomic vapor cell optical outlet (4) and wherein the shape of the pipe outlet face (16) is substantially equal to or smaller than the shape of the photodetector (17).

According to a fourth aspect, the invention also relates to a system for the control, adjustment, or certification of timepieces according to any of appended claims 1 to 13.

More specifically, according to the first aspect of the invention, an atomic vapor cell is provided comprising a hermetical enclosure which defines a volume containing a vapor of reference atoms. In said hermetical enclosure, there is provided an optical inlet allowing the transmission of a probe beam adapted to excite an optical transition of said reference atoms, and an optical outlet allowing the transmission of a fluorescence signal from said reference atoms. The atomic vapor cell is further remarkable in that said hermetical enclosure further comprises a wall, transparent to said fluorescence signal, which is coated on its outer side with a coating reflective to said fluorescence signal.

Unlike the process of stimulated emission, fluorescence is a spontaneous process which can occur in any direction. In the atomic vapor cells of the prior art, only the fluorescence photons spontaneously emitted in the direction of the photodetector were detected. Since the photodetectors typically have a relatively small sensitive surface, this results in very low collection efficiencies. Within the cell here disclosed, a fluorescence photon emitted in any direction (other than the photodetector) will, with high probability, reach the transparent cell wall and be reflected back into the cell by the external coating. Multiple reflections of the photon may occur, all of which increase the probability of the photon eventually reaching the optical outlet and thus the photodetector.

Some parts of the hermetic enclosure of the cell may comprise a non-transparent material, for example, if the cell comprises a silicon substrate or a metallic element being part of the hermetic enclosure. Also, some transparent parts of the hermetic enclosure may be exempt from the external coating; for example, the optical outlet is preferably defined in a transparent portion of the cell enclosure which will typically not comprise a fluorescence-reflective coating. Regarding the optical inlet, in many cases, it will also not comprise a reflective coating. The hermetic enclosure of the cell may further comprise some features, such as a sealed gas connector, used during the fabrication process for introducing the reference atoms, or some mounting and aligning structures which do not necessarily carry an external coating.

It is, on the other hand, advantageous for increasing the efficiency of fluorescence collection to maximize the surface of the hermetic enclosure being reflective to the fluorescence photons. Advantageously, the referred transparent wall coated on its outer side can represent at least 50% of the external surface of the hermetical enclosure. Preferably, the referred transparent wall coated on its outer side can represent at least 80% of the external surface of the hermetical enclosure.

As the notions of transparency and reflectiveness are not absolute, it is convenient to specify that in the context of this document, a material is considered to be transparent, or in other words, to allow the transmission of an optical signal, when the transmission of said optical signal is achieved with less than 50% losses, preferably less than 10% losses.

The notion of being reflective is somewhat harder to define, as reflectivity may strongly depend on the angle of incidence, especially in interferential coatings. In the context of this document, a coating will be considered reflective to an optical signal when, averaged over all possible angles of incidence, the reflectivity of the coating for said optical signal is at least 70%.

In the present case, the referred external coating of the wall preferably reflects at least 80% of the fluorescence signal, averaged over all possible angles of incidence.

In terms of fluorescence collection efficiency, it could be possible and even advantageous to provide the reflective coating on the inner surface of the cell walls. This is, however, not convenient in the context of an atomic vapor cell, where the presence of any atomic or molecular species within the cell, other than the reference vapor, is to be avoided. Providing the coating externally to the hermetic enclosure advantageously precludes any such contamination.

According to an advantageous embodiment, the atomic vapor cell could be integrally fabricated from transparent materials, for example, silicate or borosilicate glass, sapphire, or fused quartz, and be provided as a monolithic structure. By "monolithic" it is meant a structure where all parts are solidly merged without any joints or glues. A monolithic structure can, for example, result from a glass welding process. The monolithic structure may advantageously comprise a single transparent material, which facilitates a possible step of welding different parts. On the other hand, the monolithic structure may also comprise elements of different materials if, for example, some special properties are required at the optical inlet and outlet, while other optical or mechanical properties are sought for the cell walls.

Regarding the nature of the external coating, it can be advantageous to provide it in the form of a metallic layer. Metallic coatings are applicable on the surface of glass and other transparent materials by methods well-known in the photonics industry, such as physical vapor deposition (PVD). Metallic coatings are reflective for broad ranges of wavelengths and their reflectivity advantageously presents a relatively low dependency on the angle of incidence.

According to an advantageous embodiment, the coating may comprise an Aluminium layer with a thickness of at least 100 nm. Aluminium is a material with excellent reflectivity in the ultraviolet spectrum, conveniently adapted to the fluorescence of Rubidium atoms, which has a characteristic wavelength of 420 nm.

Alternatively, the external coating may comprise an interferential mirror. Interferential mirrors are typically formed by multiple thin layers of dielectric material having different refractive indices. The width and refractive index of the layers can be adapted to enhance the reflection of selected wavelengths. Advantageously, this type of mirror can provide very high reflectivity for specific wavelengths; for example, in this case, it can be adapted for high reflectance of the fluorescence signal. On the other hand, this type of filter is harder and more expensive to produce than a metallic coating and may have a strong dependency on the reflectivity as a function of the angle of incidence. Some known methods to produce thin dielectric layers for photonics applications include ion beam sputtering (IBS), chemical vapor deposition (CVD) or atomic layer deposition (ALD).

Advantageously, the optical inlet and outlet can be provided on planar portions of the hermetic enclosure, as opposed to a curved wall. A planar window has the advantage of (substantially) preserving the collimated profile of a laser beam used to excite the reference atoms.

It can be further advantageous to provide the optical inlet and outlet in two planar windows, separated by a peripheric cell wall, which hermetically seals a volume between said two windows.

Advantageously, the external surface of the coated wall may be textured. The texturing Advantageously, the external surface of the coated wall may be textured. The texturing can comprise random irregularities, like in a sanded glass surface, or may comprise patterns specifically configured to promote the reflection of a randomly oriented incident ray preferentially in the direction of the optical outlet. Such patterns can comprise microscopic or macroscopic features. By "microscopic" it is meant, features with characteristic sizes in the order of the optical wavelength, for example smaller than 5 microns, configured to deviate an incident beam in a given direction as a result of diffraction. By "macroscopic" it is meant, features with characteristic sizes at least 10 times larger than the optical wavelength, for example, larger than 5 microns. In an advantageous embodiment, such macroscopic features can be provided in the form of a sawtooth. Said size is preferably the distance between peaks and valleys.

In an advantageous embodiment, the reference atoms comprised in the cell can be alkali metal atoms, for example, Rubidium (Rb) atoms. Alkali metals are often used as references in atomic clocks (both optical and microwave clocks); several atomic transitions conveniently corresponding to wavelengths accessible with commercial lasers and detectors are known.

According to the second aspect of the invention, it is possible to fabricate a cell as disclosed above by a method comprising the steps of:
(S1) providing a cell body comprising an enclosure which comprises a transparent wall, and a connector defining an opening in said enclosure;
(S2) cleaning the inner surface of said cell body by a process comprising outgassing and plasma cleaning;
(S3) Introducing a vapor of reference atoms into the enclosure through the connector;
(S4) hermetically sealing the connector to obtain a hermetical enclosure defining a volume containing a vapor of reference atoms; and
(S5) depositing a coating reflective to a fluorescence signal of said reference atoms on at least part of the surface of said transparent wall.

Obviously, the transparency of the wall referred to above is defined at least for the wavelength of the fluorescence signal and/or for the wavelength of the interrogation signal.

Advantageously, the disclosed method may further comprise a step (S6) comprising texturing the outer surface of said transparent wall. Said step S6 may be performed at any stage before applying the reflective coating in step S5. For example, step S6 may be performed on a filled and sealed cell after step S4. Alternatively, step S6 could also be performed after or even before step S1. For example, the cell body could be provided by assembling different cell parts, wherein some of said cell parts could be textured before the assembly of the cell.

According to the third aspect of the invention, an optical atomic clock is provided, recognizable in that it comprises an atomic vapor cell as described above.

An atomic vapor cell, as provided in the present invention, has the advantage of enabling a more efficient collection of a fluorescence signal produced by the reference atoms. For a given power of the interrogation beam (also called the probe beam), a higher collection efficiency results in a higher detected signal and consequently, lower shot noise and higher stability of the clock. While in principle a low collection efficiency could be compensated by increasing the power of the probe beam, this is not desirable as a stronger probe beam enhances the light-shift instability of the clock. Indeed, one of the major sources of instability in optical atomic clocks comes from the AC Stark shift affecting the transition frequency of the atoms, resulting from the optical field of the interrogation laser itself. Power variations of the interrogation laser generate fluctuations of the energy of the reference transition, producing instability in the clock frequency, commonly referred to as light-shift instability. Since the light-shift coefficient depends on the square of the excitation beam intensity, it is convenient to implement a probe beam with low intensity, but still sufficient to produce a sensible fluorescence signal. An optical atomic clock comprising a cell as disclosed here, enabling good collection efficiency, is thus advantageous in that it may be operated with a relatively low probe power, resulting in reduced light-shift instability, while also delivering a large fluorescence signal at the detector, resulting in low shot-noise instability.

Advantageously, said optical atomic clock can be based on two-photon absorption detected through a fluorescence signal from the reference atoms, and the optical scheme can be arranged according to a doppler-free configuration. As said before, a doppler -free configuration results in a spectrally narrow absorption band which provides the two-photon optical atomic clock with high frequency precision.

According to one advantageous embodiment, at the optical outlet side of the atomic vapor cell, the optical atomic clock may be provided with a light-pipe, configured to capture the fluorescence signal from the reference atoms and to transfer said fluorescence signal to a photodetector which may be positioned at a safe distance from the cell. By "safe distance" it is meant that the photodetector and the cell are sufficiently spaced apart such that the heating which is typically applied to the atomic vapor cell has a reduced impact on the temperature of the photodetector. For example, the atomic vapor cell and the photodetector can be placed 1 cm apart, or more. According to this embodiment, such a separation would not result in a loss of fluorescence signal since the light-pipe can effectively carry the fluorescence photons from the cell optical outlet to the photodetector.

A light-pipe can be configured as a light transmitting element, having a pipe inlet face, a pipe outlet face, and reflective walls. A light-pipe can be provided, for example, as a hollow tube with internally reflective walls, where the inlet and outlet faces are simply the openings of said hollow tube. Alternatively, a light-pipe can be provided as a tube of bulk transparent material. The reflection of light at the walls of such a light-pipe can advantageously result from internal reflection of the light at the interface of the transparent tube. The tube may additionally comprise a reflective coating to reduce the losses of light impinging on the interface with a relatively large angle with respect to the surface. A light-pipe can also be provided as a curved or flexible optical guide, such as a multimode optical fibre.

The light-pipe may be conveniently adapted such that the shape of the pipe outlet is substantially equal to or smaller than the shape of the photodetector. By "shape of the photodetector", it must be understood in this case, the shape of the photosensitive element or of the optical window at the entrance of the photo-detecting device. Such matching of shapes is meant to ensure that every photon carried by the light-pipe to the pipe outlet effectively reaches the photodetector.

Additionally, the light-pipe may be conveniently adapted such that the shape of the pipe inlet is substantially equal to or larger than the shape of the atomic vapor cell outlet. Such matching of shapes is meant to ensure that every fluorescence photon emitted from the cell effectively enters the light-pipe.

In this document, the relations between shapes are defined as follows. A first shape is larger than a second shape, if all the points of the second shape can be orthogonally projected on the first shape. A first shape and a second shape are equal, if all the points of the contour of the second shape can be orthogonally projected on the contour of the first shape.

When the atomic vapor cell optical outlet and the photodetector have significantly different shapes, the light-pipe can advantageously have a tapered tubular form and serve as a shape-matching light coupling element.

According to the fourth aspect of the invention, a system for the control, adjustment, or certification of timepieces is provided, characterized in that it comprises the above-disclosed optical atomic clock. Such a system comprises means to measure the frequency signal and/or the rate of a timepiece or of several timepieces.

### Brief description of the drawings

Further details of the invention and other advantageous embodiments will appear more clearly upon reading the description below, in connection with the following figures which illustrate:
- Fig. 1: Atomic vapor cell according to one embodiment of the invention.
- Fig. 2: Detail of an atomic vapor cell according to another embodiment of the invention.
- Fig. 3: Block diagram of a method for fabricating an atomic vapor cell according to a second aspect of the invention.
- Fig. 4: Illustration of some steps of the method of Fig. 3 according to a possible embodiment.
- Fig. 5: Schematic illustration of a first example of part of an optical atomic clock according to a third aspect of the invention.
- Fig. 6: Schematic illustration of a second example of part of an optical atomic clock according to a third aspect of the invention.
- Fig. 7: Schematic illustration of a system for the control, adjustment, or certification of timepieces according to a fourth aspect of the invention.

### Embodiments of the invention

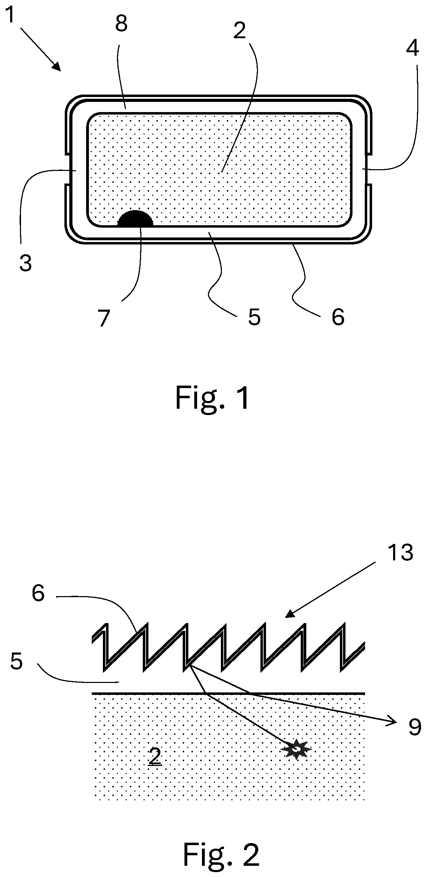

Fig. 1 illustrates an atomic vapor cell 1 according to one embodiment of the invention. The atomic vapor cell 1 comprises:
   - an hermetical enclosure 8, in particular an hermetically sealed enclosure 8, and
   - a vapor of reference atoms 2 contained within the volume defined by the hermetical enclosure 8 of the cell 1.

The hermetical enclosure 8 comprises:
- an optical inlet 3, which defines a passage allowing the transmission of light into the cell, for example the transmission of a probe beam adapted to excite an optical transition of the reference atoms 2, and
- a transparent wall 5 coated on its outer side with a reflective coating 6. In this context, the transparency of the wall 5 and the reflectivity of the coating 6 are referred to the wavelength of the fluorescence signal emitted by the reference atoms 2.

Moreover, as in the represented embodiment example, the hermetical enclosure 8 includes an optical outlet 4, which defines a passage allowing the transmission out of the cell of a fluorescence signal emitted by the reference atoms 2.

In the represented embodiment example, the rest of the hermetical enclosure 8 (excluding the optical inlet and the optical outlet) is provided as a transparent wall 5 coated on its outer side with a reflective coating 6.

Although in the example of Fig. 1, the optical inlet 3 and optical outlet 4 are disposed at two opposite sides of the hermetical enclosure 8, in a possible alternative embodiment, they could be provided at different positions, or even be coincident on the same side of the atomic vapor cell 1. Indeed, the atomic vapor cell 1 could comprise a single optical passage in the hermetical enclosure 8, serving both as inlet 3 of the probe beam and outlet 4 of the fluorescence signal. In such a case, considering that the fluorescence and the probe beams have generally different wavelengths (especially in two-photon schemes), it would be possible to spectrally separate both signals using, for example, a dichroic mirror.

Not represented in Fig. 1, the atomic vapor cell 1 may additionally comprise a sealed connector element which may have been used during the fabrication to introduce the atomic vapor.
Fig. 1 further illustrates, at the inner surface of the hermetical enclosure 8, a possible residual condensation 7 of the reference atoms 2, in equilibrium with the vapor phase which may result from the cell filling process as will be explained later.
Fig. 2 illustrates a detail of the transparent wall 5 of the cell according to an advantageous embodiment. Here the transparent wall 5 is provided with a textured external area wherein the texture is configured to promote the reflection of a randomly oriented incident ray 9 preferentially in the direction of the optical outlet 4 (not represented but presumed to be at the right of the figure, as in Fig. 1). For illustration purposes, the figure depicts the trajectory of a fluorescence ray emitted by a reference atom 2 within the cell.

In this example, the external area of the wall is textured according to a geometry appearing as a sawtooth pattern in cross-section illustrated on Fig. 2. The geometry of the external area may be an alternating series of:
- planes (perpendicular to the probe beam direction), and
- frustoconical faces.

On fig. 2, each tooth of the pattern can be, for example:
- the intersection between a frustoconical face or groove around a cylindrical cell wall and the cross-section plane of fig. 2, and
- the intersection between a plane (perpendicular to the probe beam direction) and the cross-section plane of fig. 2.

The frustoconical faces or grooves are oriented towards the optical outlet 4 of the cell, to promote the reflection of the fluorescence in this preferential direction. The depth and period of the sawtooth pattern may advantageously be between 0.2 and 2 mm. Advantageously, all the geometries that allow to improve the deflection and/or focusing of the fluorescence signal towards the optical outlet 4 may be used.

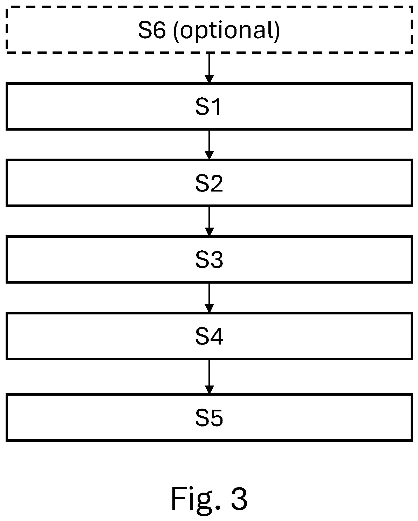

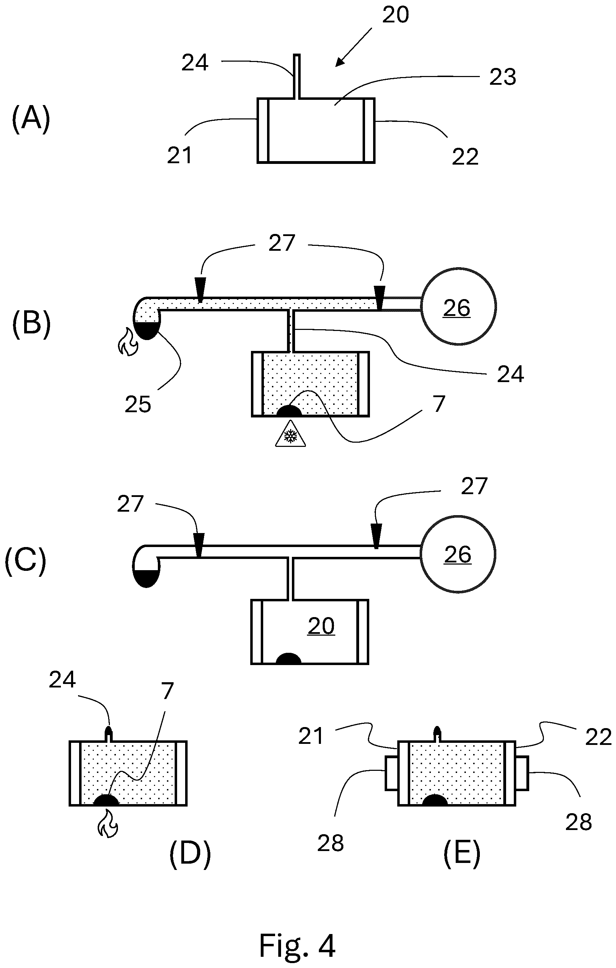

Fig. 3 presents a block diagram of a method for fabricating an atomic vapor cell according to one embodiment of a second aspect of the invention, while Fig. 4 illustrates some stages of this fabrication method.

In step S1, a cell body 20 is provided, as illustrated in Fig. 4A. The cell body 20 comprises an enclosure and a connector 24 defining an opening in said enclosure. The enclosure comprises two planar windows 21, 22, and an open cylindrical wall 23.

In this example, all the parts of the cell body 20 are advantageously made of a single transparent material, for example, optical glass, and are assembled together as a monolithic structure by a process of glass welding.

In an optional step (S6) prior to the assembly of the cell, some of these parts, for example, the cylindrical wall 23, may be textured on its outer surface according to one advantageous embodiment.

The texturing can be provided through a sandblasting step, resulting in a random texture. Alternatively, the texture may comprise regular designed features, such as a sawtooth pattern which can be produced through a mechanical or laser machining process, photolithography, or a hot embossing process.

Once the cell is assembled, a cleaning step S2 is performed comprising outgassing and plasma cleaning, in order to remove any impurities, particularly from the inner surface of the cell body 20. The outgassing can be realized, for example, by heating the enclosure 20 at a temperature above 100°C while keeping it under high vacuum (< 10⁻⁵ mbar). The plasma cleaning can be performed by injection of a low -pressure gas within the cells (about 10 mbar) and by ionization of it by an RF field so that a plasma is created. The energetic bombardment from the plasma breaks down molecular bonds, removing contaminants from the surface. Then the gas and the contaminants, now volatile, are removed by vacuum pumping.

In the next step S3, a vapor of reference atoms is introduced in the cell body.

There are several possible ways of doing this. In the example of Fig. 4B, the connector 24 is connected to a glass tubing system. On one branch of said tubing system, there is provided a reservoir 25 comprising a condensate of the reference atoms, for example, a condensate of pure Rb atoms. Another branch of said tubing system is connected to a high-vacuum pump 26. The tubing system further comprises valves 27 to open or close the connection between the cell enclosure and the different branches of the tubing system.

Initially, both valves can be opened and the whole tubing system, including the cell enclosure, are emptied of any gas through the pump 26.

In a following sub-step illustrated in Fig. 4B, the path to the vacuum pump 26 is closed. The reservoir 25 is heated, for example, at a temperature between 70°C and 100°C to produce a vapor of Rb atoms, which diffuses through the tubing into the cell enclosure. Advantageously, a surface of the cell enclosure may be cooled, for example, by circulating a cooled liquid, or applying a cold finger to said surface, resulting in the formation of a condensate 7 of said reference atoms within the enclosure.

In an alternative embodiment of this sub-step, the reservoir 25 could contain a precursor compound of the reference atoms, instead of a pure condensate. For example, the reservoir could contain Rubidium metal azide (RbN₃), which can be decomposed by heating or by the application of ultraviolet radiation into vapors of Rubidium atoms and nitrogen.

In an optional following sub-step illustrated in Fig. 4C, the path to the vacuum pump 26 is reopened and the cell is emptied again of any vapors. This step could be used, for example, to evacuate any nitrogen gas or remnants of any solvent possibly used to initially dispense the Rubidium metal azide into the reservoir 25. Following this sub-step, a pure condensate 7 of the reference atoms is left inside the enclosure.

After step S3, step S4 is performed to hermetically seal the connector, thus obtaining a hermetical enclosure defining a volume containing a vapor of reference atoms. In the example of Fig. 4D, this step could comprise flaming the glass connector 24 to collapse its inner channel, sealing the cavity, and ultimately breaking the sealed connector apart from the glass tubing used in the filling step S3.

As illustrated in Fig. 4D, the condensate 7 will produce a vapor of reference atoms inside the hermetically sealed cell. The density of this vapor can be increased by heating the cell. Such heating can be, for example, continuously applied during the operation of an optical atomic clock comprising this cell.

In a final step S5, a coating reflective of a fluorescence signal of the reference atoms is applied on at least part of the surface of the enclosure.

A convenient method of applying said coating can be through a physical vapor deposition process, which results in a reflective metallic layer being deposited all around the external envelope of the cell.

Advantageously, as illustrated in Fig. 4E, a removable protection 28 can be provided at specific places of the envelope, in this example, at the planar windows 21, 22 to prevent the deposition of the coating at said specific places. The protection can be, for example, a removable resin, or any other sticky polymer which can be later removed without damaging the window or leaving solid residues at its surface. Once the coating has been applied, the protections 28 can be removed to expose the uncoated parts of the transparent surface which can then serve as optical inlet and outlet of the atomic vapor cell.

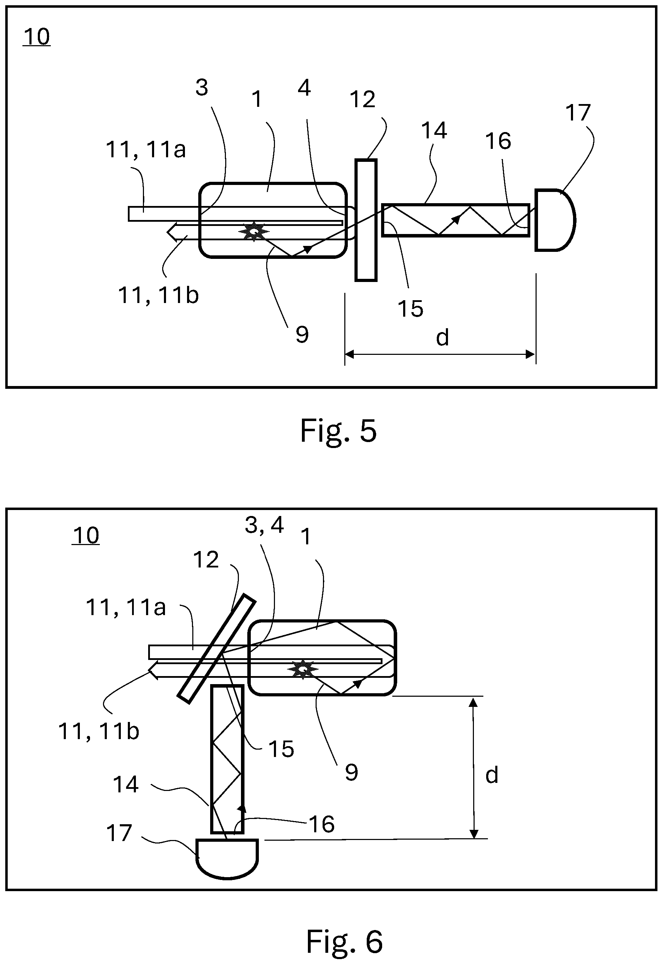

Fig. 5 illustrates a first example of part of an optical atomic clock 10 according to a third aspect of the invention. The optical atomic clock 10 comprises an atomic vapor cell 1 according to the present disclosure. The optical atomic clock may further include:
- a laser source adapted to generate a probe beam 11,
- a dichroic mirror 12,
- an eventual light guide or a light pipe 14, and
- an eventual photodetector 17.

The generated probe beam 11 is provided at a wavelength adapted to excite an optical transition, for example a two-photon optical transition, of the reference atoms in the cell 1.

Advantageously, in this embodiment, the optical path of the probe beam across the reference vapor is configured with a double passage 11a, 11b enabling doppler-free absorption. The probe beam 11a enters the cell 1 through the optical inlet 3, crosses the volume containing the vapor, and reaches the optical outlet 4 where it exits the cell. A dichroic mirror 12, adapted to reflect the probe beam while transmitting a fluorescence signal from the reference atoms, reflects the probe beam 11b backwards through the same optical path, re-entering the cell 1 through the outlet 4 and exiting the cell through the inlet 3.

In Fig. 5, the paths of the incoming beam 11a and the retroreflected beam 11b are represented as if they were spatially shifted. This is only for the purpose of illustration. In reality, the optical path of the beam in the two directions 11a, 11b is exactly the same. This results in the preferential absorption of two counter-propagating photons, which is not affected by the doppler effect, regardless of the direction and speed of the absorbing atom in vapor phase.

While the dichroic mirror 12 in Fig. 5 is depicted as an independent optical element, it is clear that it could also be implemented as an interferential coating provided at the outer surface of the optical outlet 4. Other combinations of spectral separation between the fluorescence signal and the probe beam, before the re-injection of the probe beam backwards into the cavity, can also be conceived by the person skilled in the art without departing from the scope of the invention.

Fig. 6 illustrates a second example of part of an optical atomic clock 10 according to the third aspect of the invention. The second example differs from the first example mainly or exclusively in that:
- it uses an atomic vapor cell 1the optical inlet 3 and optical outlet 4 of which are coincident on the same side, and
- the dichroic mirror 12 is arranged in a non-perpendicular configuration regarding the probe beam at the exit of the optical passage 3, 4. In such an embodiment, the dichroic mirror is configured to reflect the fluorescence signal towards the photodetector 17.

Having a single optical passage serving both as inlet 3 of the probe beam and outlet 4 of the fluorescence signal, as in the example of Fig. 6, not only constitutes an alternative configuration of the optical atomic clock 10. This scheme advantageously allows a more effective magnetic shielding of the atomic vapor cell 1. Magnetic fields are known to influence the energy of atomic transitions. For this reason, in many atomic clocks, the atomic cell is protected with a magnetic shield, comprising for example a High Permeability Magnetic Shielding Alloy, such as Mu-metal^{®}. In a configuration of the optical atomic clock as depicted in Fig. 5, such magnetic shield would present at least two apertures, allowing the transmission of light through the optical inlet 3 and outlet 4. In contrast, a configuration as depicted in Fig. 6 allows providing a magnetic shield presenting only one aperture, corresponding to the single optical passage 3, 4 of the cell, thus providing an improved magnetic shielding.

Another aspect illustrated in Fig. 5 and 6, which is, in principle, independent of the doppler-free configuration discussed above, is the advantageous provision of the light-pipe 14, which optically couples the photodetector 17 with the cell outlet 4, or in the present example with the interposed dichroic mirror 12. The light-pipe 14 has a tubular form, comprisinga pipe inlet face 15, a pipe outlet face 16, and reflective walls along its length.

In the optical atomic clock 10, in particular in examples of fig. 5 and 6, the photodetector 17 may advantageously be a photomultiplier tube (PMT). The light-pipe 14 allows efficient transmission of the fluorescence photons towards the photodetector 17, while respecting a safe distance d. Advantageously, said distance d between said photodetector 17 and the cell 1 may be at least 1 cm. This distance preserves the temperature-sensitive photodetector 17 from the heating which is typically applied to the cell 1 to increase and control the atomic vapor density.

In these examples, the shape and size of the pipe inlet face 15 is substantially equal to the shape and size of the cell optical outlet 4. Also, the shape and size of the pipe outlet face 16 is substantially equal to the shape and size of the input window of the photodetector 17.

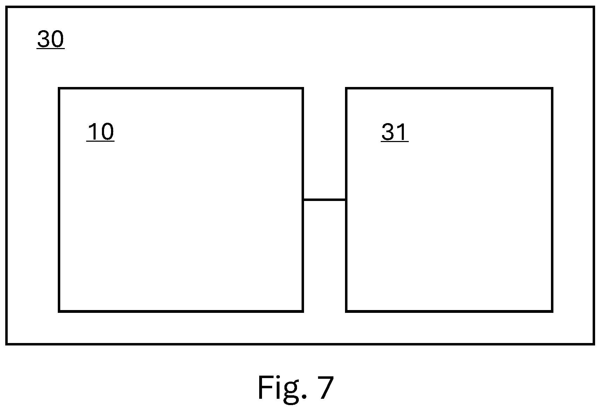

Fig. 7 illustrates a system 30 for the control, adjustment, or certification of timepieces, according to a fourth aspect of the invention.

The system 30 comprises an optical atomic clock 10 as provided in the present disclosure. The system 30 further comprises means 31 to measure the frequency signal and/or the rate of a timepiece or several timepieces.

Such means 31 can be for example a device to measure the rate by recording and analyzing the acoustic signal emitted by the timepiece, notably the acoustic signal emitted through the function of the escapement and balance-spring oscillator in a mechanical timepiece. Alternatively or complementarily, such means 31 can be a device to measure the rate by optically measuring the oscillation of a balance-spring oscillator in a mechanical timepiece. Alternatively or complementarily, such means 31 can be a device to measure the rate through visual determination of the time indicated by the timepiece at at least two different instants.

Advantageously, the measurement of the frequency signal and/or the rate of a timepiece or several timepieces by said means 31 is performed using the above-disclosed optical atomic clock 10 as a reference clock.

### Reference numerals used in the figures

- 1: Atomic vapor cell
- 2: Reference atoms
- 3: Optical inlet
- 4: Optical outlet
- 5: Transparent wall
- 6: Coating
- 7: Condensate of reference atoms
- 8: Hermetical enclosure
- 9: Ray of fluorescence signal
- 10: Optical atomic clock
- 11: Probe beam (11a : incident beam, 11b: reflected beam)
- 12: Dichroic mirror
- 13: Surface texture
- 14: Light-pipe
- 15: Pipe inlet face
- 16: Pipe outlet face
- 17: Photodetector
- 20: Cell body
- 21: Planar window
- 22: Planar window
- 23: Cell wall
- 24: Connector
- 25: Reservoir
- 26: Vacuum pump
- 27: Valves
- 28: Removable protection
- 30: System for the control, adjustment, or certification of timepieces
- 31: Means to measure the frequency signal and/or the rate of a timepiece

## Claims

1. System (30) for the control, adjustment, or certification of timepieces comprising means (31) to measure the frequency signal and/or the rate of a timepiece or of several timepieces, based on a time reference provided by an optical atomic clock (10), said optical atomic clock (10) comprising an atomic vapor cell (1),
the atomic vapor cell (1) comprising a hermetically sealed enclosure (8) defining a volume containing a vapor of reference atoms (2),
said hermetically sealed enclosure (8) comprising an optical inlet (3) allowing the transmission of a probe beam adapted to excite an optical transition of said reference atoms (2), and an optical outlet (4) allowing the transmission of a fluorescence signal from said reference atoms (2),
said hermetically sealed enclosure (8) further comprising a wall (5), transparent to said fluorescence signal, which is coated on its outer side with a coating (6) reflective to said fluorescence signal.

2. System (30) according to claim 1, wherein said wall (5) represents more than 50%, preferably more than 80%, of the external surface of the hermetically sealed enclosure (8).

3. System (30) according to claim 1 or 2, wherein said coating (6) reflects more than 70%, preferably more than 80%, of the fluorescence signal, averaged over all possible angles of incidence.

4. System (30) according to any of claims 1 to 3, wherein the optical inlet (3), the optical outlet (4), and the wall (5) are monolithically constructed comprising a material or a combination of materials transparent to both the probe and the fluorescence signals.

5. System (30) according to any of claims 1 to 4, wherein the coating (6) comprises a metallic layer or an interferential mirror.

6. System (30) according to any of claims 1 to 5, wherein the outer side of the wall (5) comprises a textured area (13).

7. System (30) according to claim 6, wherein said the textured area (13) comprises microscopic or macroscopic faces, for example frustoconical faces, arranged such as to preferentially reflect an incident fluorescence signal in the direction of the optical outlet (4).

8. System (30) according to one of claims 1 to 7, wherein said optical inlet (3) and optical outlet (4) are one and the same element.

9. System (30) according to any of claims 1 to 8, wherein the optical atomic clock (10) comprises:
- a laser source adapted to generate a laser probe beam (11) adapted to excite a two-photon optical transition of said reference atoms (2),
- a dichroic mirror (12) adapted to discriminate said probe beam (11) and a fluorescence signal (9) of said reference atoms (2), and
- a photodetector (17).

10. System (30) according to claim 9, wherein the probe beam (11), the atomic vapor cell (1), and the dichroic mirror (12) are configured such that, in operation:
- the probe beam (11a) enters the atomic vapor cell (1) through its optical inlet (3), crosses the volume containing a vapor of reference atoms (2) through a defined optical path until the optical outlet (4), crosses the optical outlet (4), reaches the dichroic mirror (12) and is reflected backwards into the optical outlet (4) towards the optical inlet (3) across said defined optical path, and
- the fluorescence signal (9) of said reference atoms (2) is transmitted through the optical outlet (4) towards the photodetector (17).

11. System (30) according to claims 8 and 9, wherein the probe beam (11), the atomic vapor cell (1), and the dichroic mirror (12) are configured such that, in operation:
- the probe beam (11a) is transmitted through the dichroic mirror (12), enters the atomic vapor cell (1) through its optical inlet (3), crosses the volume containing a vapor of reference atoms (2) through a defined optical path until a mirror and is reflected backwards towards the optical inlet (3) across said defined optical path, and
- the fluorescence signal (9) of said reference atoms (2) is transmitted through the optical outlet (4), reaches the dichroic mirror (12) and is reflected towards the photodetector (17).

12. System (30) according to any of claims 1 to 11, wherein the optical atomic clock (10) further comprises a light pipe (14) configured to capture the fluorescence signal (9) emitted from the atomic vapor cell (1), in particular through the optical outlet (4), and to transfer said fluorescence signal (9) to the photodetector (17).

13. System (30) according to claim 12, wherein the light-pipe (14) has a tubular form, defining a pipe inlet face (15), a pipe outlet face (16), and reflective walls, wherein the shape of the pipe inlet face (15) is substantially equal to or larger than the shape of the atomic vapor cell optical outlet (4) and wherein the shape of the pipe outlet face (16) is substantially equal to or smaller than the shape of the photodetector (17).
